(19)

**Europäisches Patentamt**
**European Patent Office**
**Office européen des brevets**

(11) **EP 4 775 327 A1**

(12) **EUROPEAN PATENT APPLICATION**
published in accordance with Art. 153(4) EPC

(43) Date of publication:
**15.07.2026 Bulletin 2026/29**

(21) Application number: **24862797.8**

(22) Date of filing: **03.09.2024**

(51) International Patent Classification (IPC):
*B22F 1/00* (2022.01)    *B22F 1/14* (2022.01)
*B22F 1/052* (2022.01)    *B22F 7/08* (2006.01)
*B22F 9/00* (2006.01)    *C22C 5/06* (2006.01)
*H01L 21/52* (2006.01)

(52) Cooperative Patent Classification (CPC):
**B22F 1/00; B22F 1/052; B22F 1/14; B22F 7/08;
B22F 9/00; C22C 5/06; H10W 72/071**

(86) International application number:
**PCT/JP2024/031626**

(87) International publication number:
**WO 2025/053145 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.09.2023 JP 2023146496**

(71) Applicants:
• **Daicel Corporation**
  **Osaka-shi, Osaka 530-0011 (JP)**
• **The University of Osaka**
  **Osaka 565-0871 (JP)**

(72) Inventors:
• **SAKAMOTO, Takeshi**
  **Tokyo 108-8230 (JP)**
• **UESHIMA, Minoru**
  **Tokyo 108-8230 (JP)**
• **CHEN, Chuantong**
  **Suita-shi, Osaka 565-0871 (JP)**
• **LIU, Yang**
  **Suita-shi, Osaka 565-0871 (JP)**
• **NAOE, Takuya**
  **Suita-shi, Osaka 565-0871 (JP)**

(74) Representative: **Grünecker Patent- und
Rechtsanwälte
PartG mbB
Leopoldstraße 4
80802 München (DE)**

(54) **ALLOY POWDER-CONTAINING COMPOSITION AND SEMICONDUCTOR DEVICE**

(57)    Provided is an alloy powder-containing composition that operates at high temperatures and exhibits excellent mounting properties and bonding reliability while complying with environmental regulations. The alloy powder-containing composition of the present disclosure is characterized by containing an alloy powder having an AgSi eutectic structure, a silver (Ag) powder, and an organic substance. In addition, in the present disclosure, the content of silver (Ag) relative to the total amount of the alloy powder is preferably from 15 to 97.6 mass%, the content of the silver (Ag) powder is preferably from 5 to 2000 parts by mass per 100 parts by mass of the alloy powder, and the content of silver relative to the total amount of the alloy powder and the silver (Ag) powder is preferably from 20 to 99.9 mass%.

EP 4 775 327 A1

## Description

Technical Field

The present disclosure relates to an alloy powder-containing composition and a semiconductor device. Moreover, the present application claims the rights of priority on the basis of Japanese Patent Application No. 2023-146496 filed in Japan on September 8, 2023, the content of which is incorporated herein by reference.

Background Art

Semiconductors used in power devices are required to exhibit high efficiency, minimal loss, and high frequency switching, and the use of SiC and GaN semiconductors, which are wide bandgap semiconductors, is expanding. In such a semiconductor, the operating temperature may exceed 200°C, and thus the bonding material used for bonding is required to maintain high bonding reliability even when the semiconductor is operated at high temperatures or in a harsh temperature cycle environment.

In addition, solder has been used as a high-temperature resistant bonding material in the related art, but lead-free materials are now required due to stricter environmental regulations and safety requirements. As such lead-free materials that can be used as alternatives to solder, the materials disclosed in Patent Documents 1 to 3, for example, are known.

Citation List

Patent Document

    Patent Document 1: JP 2003-311469 A
    Patent Document 2: JP 2020-069517 A
    Patent Document 3: JP 2019-56158 A

Summary of Invention

Technical Problem

However, the lead-free solder disclosed in Patent Document 1 has a low melting point and is particularly problematic in that the Sn not converted into a metal compound in the solder melts at about 230°C.

**In** addition, in the lead-free solder disclosed in Patent Document 2, bismuth (Bi) is used to achieve a high melting point, and while a high melting point can be achieved, this lead-free solder is also problematic in that cracks extend due to repeated heating, resulting in a problem with connection reliability.

**In** addition, while the silver (Ag) paste disclosed in Patent Document 3 does not melt in a usage environment of around 250°C, repeated heating causes coarsening of the metal structure and an aggregation of voids, resulting in a problem with bonding reliability.

The present disclosure solves the above problems, and an object thereof is to provide an alloy powder-containing composition that can form a bonding layer that operates at high temperatures and is excellent in mounting properties and bonding reliability while complying with environmental regulations.

Solution to Problem

As a result of intensive efforts to solve the above problems, the inventors of the present disclosure discovered that an alloy powder-containing composition containing an alloy powder having an AgSi eutectic structure, a silver (Ag) powder, and an organic substance is operable at high temperatures and exhibits excellent mounting properties and bonding reliability while complying with environmental regulations.

That is, the present disclosure provides an alloy powder-containing composition containing: an alloy powder having an AgSi eutectic structure; a silver (Ag) powder; and an organic substance.

Because the alloy powder-containing composition contains the alloy powder having the AgSi eutectic structure, the silver (Ag) powder, and the organic substance, silver (Ag) in the AgSi eutectic structure present on the surface is recrystallized by heating during sinter bonding and thus can be exuded from the surface of the alloy powder, resulting in excellent mounting properties. In addition, the linear expansion coefficient of the alloy powder itself can be reduced while firm bonding to an adherend is maintained, and therefore, the bonding reliability at high temperatures is excellent.

Furthermore, since silver (Ag) and silicon (Si) are used as raw materials, the alloy powder-containing composition is also compliant with environmental regulations.

In the alloy powder-containing composition, the content of silver (Ag) relative to the total amount of the alloy powder is preferably from 15 to 97.6 mass%.

The content of the silver (Ag) powder in the alloy powder-containing composition is preferably from 5 to 2000 parts by mass per 100 parts by mass of the alloy powder.

In the alloy powder-containing composition, the content of silver relative to the total amount of the alloy powder and the silver (Ag) powder is preferably from 20 to 99.9 mass%.

The alloy powder-containing composition preferably has a volume-average particle size (median diameter) of the alloy powder of from 0.1 to 100 $\mu$m.

The present disclosure also provides a semiconductor device in which the alloy powder-containing composition is used as a bonding layer for bonding the substrate and an object to be bonded.

Advantageous Effects of Invention

According to the alloy powder-containing composition of the present disclosure, a bonding layer that operates at high temperatures and exhibits excellent mounting properties and bonding reliability while complying with environmental regulations can be provided. Therefore, a semiconductor device obtained using the alloy powder-containing composition of the present disclosure can operate at high temperatures and exhibit excellent bonding reliability while complying with environmental regulations.

Brief Description of Drawings

FIG. 1 is a SEM image of a cross-section of an alloy powder of the present disclosure.
FIG. 2 is a SEM image of a cross-section of an alloy powder of the present disclosure.
FIG. 3 is a cross-sectional view schematically illustrating an example of a semiconductor device according to an embodiment of the present disclosure.

Description of Embodiments

Alloy Powder-Containing Composition

An embodiment of the present disclosure is an alloy powder-containing composition containing an alloy powder, a silver (Ag) powder, and an organic substance. The alloy powder contains silver (Ag) and silicon (Si) as raw materials, and therefore complies with environmental regulations. Moreover, the form of the alloy powder-containing composition is not particularly limited, and the composition may be in various forms. For example, an alloy powder-containing composition called an alloy ink can be prepared by dispersing the alloy powder in an appropriate organic solvent (dispersion medium) in a suspended state. Alternatively, an alloy powder-containing composition called an alloy paste can be prepared by dispersing the alloy powder in an organic solvent in a kneaded state. Among these, the alloy powder-containing composition is preferably an alloy paste.

The temperature at which the alloy powder-containing composition can be sintered is preferably from 150 to 300°C, more preferably from 160 to 280°C, and still more preferably from 200 to 270°C. When the temperature at which the alloy powder-containing composition can be sintered is 300°C or lower, sintering can be carried out at a low temperature, and a substrate having a low melting point can be used.

The heating time during sintering of the alloy powder-containing composition is preferably from 0.5 minutes to 2 hours, and more preferably from 10 minutes to 1 hour. When the heating time is within 2 hours, mounting can be carried out in a short time, and production costs can be easily reduced.

The alloy powder-containing composition is preferably pressurized when heated. Specifically, the alloy powder-containing composition is preferably pressurized at a condition of from 0.75 to 50 MPa, and more preferably from 1 to 40 MPa. In addition, if the alloy powder-containing composition is appropriately sintered and bonded, the composition need not be pressurized. Moreover, mounting can be easily carried out by setting the pressure during mounting within the above range.

The alloy powder-containing composition has a strength retention ratio (%) of preferably 50% or more, more preferably 60% or more, and still more preferably 70% or more. When the strength retention ratio is 50% or more, sufficient bonding reliability can be exhibited. The upper limit thereof is not particularly limited, but the shear bonding strength obtained through a below-described thermal shock test may increase in some cases, and therefore the upper limit of the strength retention ratio is preferably 150% or less, and more preferably 100% or less. The strength retention ratio is calculated as a ratio of the shear bonding strength after a thermal shock test in which a semiconductor device prepared under the conditions described in the Examples section below using the above alloy powder-containing composition is repeatedly heated and cooled within a range of from -50 to 250°C a specific number of times, to the shear bonding strength before the thermal shock test ((shear bonding strength after thermal shock test)/(shear bonding strength before thermal shock test) × 100), both shear bonding strengths being measured using a die shear tester ("SERIES 4000" (trade name), available from DAGE Corporation) at conditions including room temperature and a test speed of 50 μm/s.

The linear expansion coefficient of a sintered compact of the alloy powder-containing composition, as measured with a thermomechanical analyzer (device name "TMA-60", available from Shimadzu Corporation), is preferably 17 or less, more preferably 13 or less, and even more preferably 11 or less. When the linear expansion coefficient is within the above range, connection reliability is easily exhibited.

Further, when the alloy powder-containing composition is left to stand at 250°C for 100 hours and the metal structure is then observed, preferably, significant coarsening is not observed in the metal structure in the alloy powder-containing composition, and more preferably, the metal structure does not exhibit coarsening.

Alloy Powder

The proportion of the AgSi eutectic structure is preferably 10% or more in at least 8 or more of 10 particles when any 10 adjacent particles of the alloy powder are subjected to a method including selecting one particle from an image captured at a magnification of from 2000 to 50000 times, measuring the total outer peripheral length of the particle and the length of an outer peripheral portion where a eutectic structure is present, a region where no eutectic structure is present in a region from the outer periphery to a depth of 0.2 μm in a direction toward the center of the particle being excluded from the outer peripheral portion, and calculating a proportion of the length of the outer peripheral portion thereof to the total outer peripheral length as the proportion of the AgSi structure on the particle surface. As the alloy powder, one type may be used alone, or two or more types thereof may be used in combination.

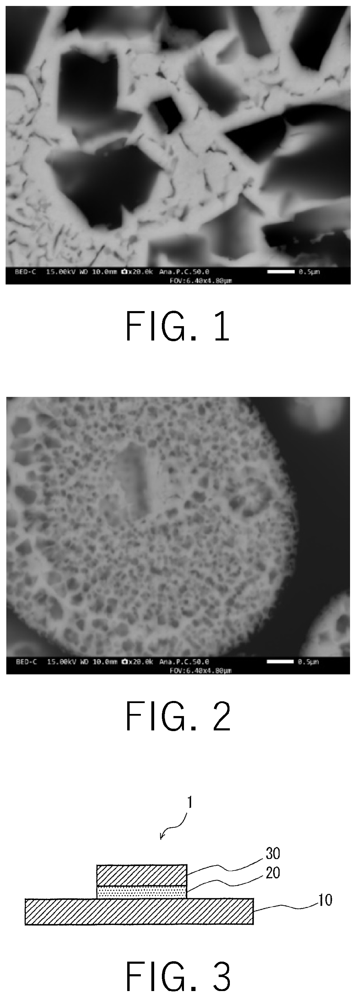

FIGS. 1 and 2 are enlarged SEM images of particle cross sections of the alloy powder. The black portions in the images are regions made of silicon (Si), and the white portions are regions made of an AgSi eutectic structure in which silicon (Si) is dispersed in Ag.

In the present disclosure, the eutectic structure is a structure unique to an eutectic alloy, and is a structure in which two types of crystal phases are simultaneously crystallized from a liquid phase at a specific temperature to form a very fine metal structure. In this case, the eutectic structure is formed at a constant compositional ratio, and when a deviation occurs in the compositional ratio, one type of crystals are crystallized first and generally grow coarsely. When the composition deviates from the composition of the ideal eutectic structure, the crystals that are crystallized first and grow while being cooled from the liquidus temperature to the eutectic temperature are called primary crystals.

For example, in a case in which the AgSi alloy contains more Si than the composition of the ideal eutectic structure, the Si crystallizes as primary crystals, and the primary crystals of Si grow, and when the AgSi composition in the remaining liquid phase becomes the ideal composition, a fine eutectic structure begins to be formed for the first time. In such an alloy powder having an AgSi eutectic structure with more Si than the compositional ratio of the eutectic, primary Si crystals of about several micrometers are dispersed in the particles, and in the AgSi eutectic structure, Si is finely dispersed in Ag at a level of around 100 nm or less. In addition, in a case in which the AgSi alloy contains more Ag than the composition of the ideal eutectic structure, the Ag crystallizes as primary crystals, and the primary crystals of Ag grow, and when the AgSi composition in the remaining liquid phase becomes the ideal composition, a fine eutectic structure begins to be formed for the first time. The size of the primary crystals also varies depending on the size of the particle, but crystals having openings of several to 10-fold or more are observed in one particle, and among these, crystals having a large size can be identified as primary crystals.

The method for producing the alloy powder having the eutectic structure is not particularly limited, and the alloy powder can be produced, for example, by a method in which a mixture of silver (Ag) and silicon (Si) heated to a liquid state is pulverized by gas atomization or water atomization.

The proportion of the AgSi eutectic structure in the alloy powder as measured by the above-described method is more preferably 15% or more, and even more preferably 20% or more. When the proportion of the AgSi eutectic structure on the particle surface is 10% or more, silver (Ag) is recrystallized and exuded from the surface of the alloy powder during sinter bonding, and bonding strength can be sufficiently exhibited.

The content of silver (Ag) in the alloy powder is preferably from 15 to 97.6 mass%, more preferably from 20 to 90 mass%, and still more preferably from 30 to 80 mass%. When the content of silver (Ag) is 15 mass% or more, the proportion of the eutectic structure on the surface of the alloy powder can be made sufficient. In addition, when the content is 97.6 mass% or less, the linear expansion coefficient can be sufficiently lowered, and production costs can be kept low while bonding reliability is exhibited.

The content of silicon (Si) in the alloy powder is preferably from 2.4 to 85 mass%, more preferably from 10 to 80 mass%, and even more preferably from 20 to 70 mass%. When the content of silicon (Si) in the alloy powder is 2.4 mass% or more, the linear expansion coefficient can be kept sufficiently low, and production costs can be kept low while bonding reliability is exhibited. Moreover, when the content thereof is 85 mass% or less, the proportion of the eutectic structure on the surface of the alloy powder can be maintained at a sufficient level.

The alloy powder may contain other components in addition to silver (Ag) and silicon (Si), but from the viewpoint of obtaining an alloy powder-containing composition that can operate at high temperatures and exhibits connection reliability while complying with environmental regulations, the alloy powder preferably does not contain components other than silver (Ag) and silicon (Si).

The total content of silver (Ag) and silicon (Si) in the alloy powder relative to the total amount of the alloy powder is preferably 90 mass% or more, more preferably 95 mass% or more, and still more preferably 100 mass%.

The volume-average particle size (median diameter) of the alloy powder is preferably from 0.1 to 100 $\mu$m, more preferably from 0.3 to 50 $\mu$m, even more preferably from 0.5 to 10 $\mu$m, and particularly preferably from 0.5 to 3 $\mu$m. When the volume-average particle size is 0.1 $\mu$m or more, handling is facilitated, and when the volume-average particle size is 100 $\mu$m or less, the amount of surface area of the alloy powder becomes sufficient, and bonding is easily carried out in a short time. The volume-average particle size (median diameter) can be measured by a laser diffraction/scattering method.

The shape of the alloy powder is not particularly limited, and examples include a spherical shape, a flake shape (flat shape), and a polyhedral shape. Alloy powders of the same shape may be used alone, or alloy powders of different shapes may be used in combination. Of these, the alloy powder is preferably spherical.

The alloy powder-containing composition contains the abovementioned organic substance. As the organic substance, one type may be used alone, or two or more types thereof may be used in combination.

Examples of the organic substance include an organic solvent, a binder resin, and an additive.

The abovementioned organic solvent preferably includes at least an organic solvent (a), an organic solvent (b), and an organic solvent (c). The organic solvent (a), the organic solvent (b), and the organic solvent (c) are different compounds and satisfy Expressions (1) to (6) below. Only one type of each of the organic solvent (a), the organic solvent (b), and the organic solvent (c) may be used, or two or more types thereof may be used.

$$150°C \leq Ta \leq 250°C \ (1)$$

$$150°C \leq Tb \leq 250°C \ (2)$$

$$250°C \leq Tc \leq 350°C \ (3)$$

$$\delta a \geq 10.0 \ (4)$$

$$\delta c \leq 9.0 \ (5)$$

$$\delta c \leq \delta b \leq \delta a \ (6)$$

In the expressions, Ta to Tc represent the boiling points of the organic solvents (a) to (c), respectively, and $\delta a$ to $\delta c$ represent the Hansen solubility parameters of the organic solvents (a) to (c), respectively. In the present specification, the Hansen solubility parameter may be referred to as "SP value" and described as "$\delta$".

The organic solvents (a) to (c) only need to be uniformly dissolved to form a liquid state when mixed at a blending ratio used in the bonding conductive paste, and each of them may be in a liquid state or a solid state at room temperature by itself.

The organic solvent (a) satisfies at least Expression (1). That is, the boiling point Ta of the organic solvent (a) satisfies 150°C $\leq$ Ta $\leq$ 250°C, preferably satisfies 150°C < Ta < 250°C, more preferably satisfies 155°C $\leq$ Ta $\leq$ 220°C, and even more preferably satisfies 160°C $\leq$ Ta $\leq$ 200°C. When the organic solvent (a) having a boiling point within the above range is used, the organic solvent is easily volatilized during sintering, and a sintered compact can be easily formed.

The organic solvent (a) satisfies at least Expression (4) [$\delta a \geq 10.0$]. The SP value $\delta a$ of the organic solvent (a) is 10.0 or more, preferably 10.3 or more, and more preferably 10.4 or more, as long as the SP value $\delta a$ is within the range that satisfies Expression (6). When the $\delta a$ is 10.0 or more, the dispersibility of the alloy powder and the below-described metal particles is excellent, and separation of the alloy powder and silver powder from the organic solvent does not easily occur. The $\delta a$ of the organic solvent (a) is, for example, 16.0 or less and may be 15.0 or less.

EP 4 775 327 A1

Examples of the organic solvent (a) include an alcohol solvent, a urea-based solvent, and an aprotic polar solvent. Examples of the alcohol solvent include compounds having one or more hydroxy groups. Among them, a tertiary alcohol and an ether alcohol are preferred. The alcohol solvent may have two or more hydroxy groups. The ether alcohol is a compound having an ether bond and a hydroxy group, and examples thereof include a (poly)alkylene glycol monoalkyl ether and an alkoxy group-substituted alcohol.

Specific examples of the organic solvent (a) include pinacol ($\delta$ 10.7, boiling point 172°C), tetramethylurea ($\delta$ 10.6, boiling point 177°C), 3-methoxybutanol ($\delta$ 10.6, boiling point 161°C), 1-methylcyclohexanol ($\delta$ 10.4, boiling point 155°C), and methyl carbitol (diethylene glycol monomethyl ether) ($\delta$ 10.7, boiling point 193°C).

The organic solvent (b) satisfies at least Expression (2). That is, the boiling point Tb of the organic solvent (b) satisfies $150°C \leq Tb \leq 250°C$, preferably satisfies $150°C < Tb < 250°C$, more preferably satisfies $180°C \leq Tb \leq 248°C$, and even more preferably satisfies $200°C \leq Tb \leq 245°C$. When the organic solvent (b) having a boiling point within the above range is used, the organic solvent is easily volatilized during sintering, and a sintered compact can be easily formed. When the organic solvent (b) having a boiling point of 250°C or lower is used, void generation during sintering can be suppressed.

The organic solvent (b) satisfies at least Expression (6). The SP value $\delta b$ of the organic solvent (b) is preferably from 8.0 to 12.0, more preferably from 8.5 to 11.0, and even more preferably from 9.0 to 10.5, as long as the SP value $\delta b$ is within the range that satisfies Expression (6). When the $\delta b$ is within the above range, there is a tendency that the miscibility between the organic solvent (a) and the organic solvent (c) is improved, separation is less likely to occur, and continuous discharge stability and storage stability are more excellent.

Examples of the organic solvent (b) include an alcohol solvent, an ester solvent, a ketone solvent, and an amine-based solvent. Examples of the alcohol solvent include solvent compounds having one or more hydroxy groups. Among them, a tertiary alcohol, an ether alcohol, and an ester alcohol are preferred. The ether alcohol is a compound having an ether bond and a hydroxy group, and examples thereof include a (poly)alkylene glycol monoalkyl ether and an alkoxy group-substituted alcohol. The ester alcohol is a compound having an ester bond and a hydroxy group, and examples thereof include a (poly)alkylene glycol monoalkyl ether monoester. Examples of the ester solvent include diacetates of diols such as (poly)alkylene glycols. The ketone solvent is preferably a cyclic ketone. The amine-based solvent is preferably an alkylamine.

The organic solvent (b) is selected on the premise that it satisfies Expression (6) in the relationship with the organic solvents (a) and (c). Specific examples of the organic solvent (b) that can be used include d-Camphor (camphor) ($\delta$ 10.4, boiling point 204°C), 1-heptanol ($\delta$ 10.0, boiling point 177°C), butyl carbitol (diethylene glycol monobutyl ether) ($\delta$ 10.2, boiling point 231°C), ethyl carbitol (diethylene glycol monoethyl ether) ($\delta$ 10.5, boiling point 196°C), tripropylene glycol monomethyl ether ($\delta$ 9.4, boiling point 243°C), $\alpha$-terpineol ($\delta$ 9.3, boiling point 220°C), dihydroterpineol ($\delta$ 9.0, boiling point 210°C), 1,3-butanediol diacetate ($\delta$ 9.2, boiling point 232°C), propylene glycol diacetate ($\delta$ 9.3, boiling point 190°C), butyl carbitol acetate ($\delta$ 9.0, boiling point 247°C), dipropylene glycol butyl ether ($\delta$ 9.2, boiling point 230°C), isophorone ($\delta$ 9.5, boiling point 213°C), 1-decanol ($\delta$ 9.6, boiling point 230°C), propylene glycol monobutyl ether ($\delta$ 9.0, boiling point 170°C), and 1-nonanol ($\delta$ 9.8, boiling point 214°C).

Preferably, the boiling point Tb of the organic solvent (b) is higher than the boiling point Ta of the organic solvent (a), that is, Tb > Ta. The temperature difference between Tb and Ta [Tb - Ta] is preferably 2°C or more, more preferably 5°C or more, and even more preferably 10°C or more. When the temperature difference is 2°C or more, void generation during sintering can be further suppressed.

The organic solvent (c) satisfies at least Expression (3). That is, the boiling point Tc of the organic solvent (c) satisfies $250°C \leq Tc \leq 350°C$, preferably satisfies $250°C < Tc < 350°C$, more preferably satisfies $250°C < Tc \leq 320°C$, and even more preferably satisfies $250°C < Tc \leq 300°C$. When the organic solvent (c) having a boiling point within the above range is used, rapid volatilization of the organic solvent (a) and the organic solvent (b) and void generation can be suppressed during sintering.

The organic solvent (c) satisfies at least Expression (5) [$\delta c \leq 9.0$]. The SP value $\delta c$ of the organic solvent (c) is 9.0 or less, preferably 8.7 or less, and more preferably 8.5 or less. When the $\delta c$ is 9.0 or less, void generation during sintering can be suppressed. The $\delta c$ of the organic solvent (c) is, for example, 6.0 or more and may be 7.0 or more.

Examples of the organic solvent (c) include an ether solvent, an alkane solvent, and an ester solvent. Examples of the ether solvent include (poly)alkylene glycol dialkyl ether. The alkane solvent is preferably an alkane having 14 or more carbon atoms (for example, from 14 to 20 carbon atoms). Examples of the ester solvent include esters of (poly)alkylene glycol alkyl ethers and fatty acids.

Specific examples of the organic solvent (c) include dibutyl carbitol (diethylene glycol dibutyl ether) ($\delta$ 8.3, boiling point 255°C), tetradecane ($\delta$ 7.9, boiling point 254°C), and hexadecane ($\delta$ 8.0, boiling point 287°C).

Preferably. the boiling point Tc of the organic solvent (c) is higher than the boiling point Tb of the organic solvent (b), that is, Tc > Tb. The temperature difference between Tc and Tb [Tc - Tb] is preferably 2°C or more, more preferably 6°C or more, and even more preferably 10°C or more. When the temperature difference is 2°C or more, void generation during sintering can be further suppressed.

Preferably, the boiling point Tc of the organic solvent (c) is higher than the boiling point Ta of the organic solvent (a), that is, Tc > Ta. The temperature difference between Tc and Ta [Tc - Ta] is preferably 30°C or more, more preferably 50°C or more, and even more preferably 60°C or more. When the temperature difference is 30°C or more, void generation during sintering can be further suppressed.

The relationship among the SP value δa of the organic solvent (a), the SP value δb of the organic solvent (b), and the SP value δc of the organic solvent (c) satisfies Expression (6) [δc ≤ δb ≤ δa] above. In particular, preferably, δb is preferably higher than δc, that is, δc < δb is satisfied. In addition, preferably, δa is higher than δb, that is, δb < δa is satisfied.

The difference between δb and δc [δb - δc] is preferably 0.1 or more, more preferably 0.2 or more, and even more preferably 0.5 or more. When the difference is 0.1 or more, the dispersibility of the metal particles is more excellent, and the continuous discharge stability is more excellent. The difference is preferably 2.0 or less, more preferably 1.5 or less, and even more preferably 1.3 or less. When the above difference is 2.0 or less, the alloy powder and silver powder are not easily separated from the organic solvent, and the continuous discharge stability and the storage stability are more excellent.

The difference between δa and δb [δa - δb] is preferably 0.1 or more, more preferably 0.2 or more, and even more preferably 0.5 or more. When the difference is 0.1 or more, the dispersibility of the metal particles is more excellent, and the continuous discharge stability is more excellent. The difference is preferably 2.5 or less, more preferably 2.0 or less, and even more preferably 1.8 or less. When the above difference is 2.5 or less, the alloy powder and the silver powder do not easily separate from the organic solvent, and the continuous discharge stability and the storage stability are more excellent.

The difference between δa and δc [δa - δc] based on Expressions (4) and (5) is 1.0 or more, preferably 1.5 or more, and more preferably 2.0 or more. When the difference is 1.0 or more, void generation during sintering can be further suppressed. The difference is preferably 5.0 or less, more preferably 4.0 or less, and even more preferably 3.0 or less. When the above difference is 5.0 or less, the alloy powder and the silver powder do not easily separate from the organic solvent, and the continuous discharge stability and the storage stability are more excellent.

The proportion of the organic solvent (a) relative to 100 mass% of the total amount of the organic solvent (a), the organic solvent (b), and the organic solvent (c) [organic solvent (a)/ {organic solvent (a) + organic solvent (b) + organic solvent (c)}] is preferably from 5 to 70 mass%, more preferably from 10 to 60 mass%, and even more preferably from 15 to 50 mass%. When the proportion is within the above range, the organic solvent is easily volatilized during sintering, a sintered compact can be easily formed, and the dispersibility of the alloy powder and the silver powder is more excellent.

The proportion of the organic solvent (b) relative to 100 mass% of the total amount of the organic solvent (a), the organic solvent (b), and the organic solvent (c) [organic solvent (b)/ {organic solvent (a) + organic solvent (b) + organic solvent (c)}] is preferably from 5 to 70 mass%, more preferably from 10 to 60 mass%, and even more preferably from 15 to 50 mass%. When the proportion is within the above range, the miscibility among the organic solvents is excellent, and continuous discharge stability and storage stability are more excellent.

**The proportion** of the organic solvent (c) relative to 100 mass% of the total amount of the organic solvent (a), the organic solvent (b), and the organic solvent (c) [organic solvent (c)/ {organic solvent (a) + organic solvent (b) + organic solvent (c)}] is preferably from 5 to 70 mass%, more preferably from 10 to 60 mass%, and even more preferably from 15 to 50 mass%. When the proportion is within the above range, void generation during sintering can be further suppressed.

The content of the organic solvent (c) relative to 100 parts by mass of the organic solvent (a) is preferably from 20 to 400 parts by mass, more preferably from 30 to 300 parts by mass, and even more preferably from 50 to 200 parts by mass. When the content is within the above range, the blending amounts of the organic solvent (a) and the organic solvent (c) are well balanced, and void suppression during sintering and dispersibility of the alloy powder and silver powder are further improved.

The content of the organic solvent (b) relative to 100 parts by mass of the total amount of the organic solvent (a) and the organic solvent (c) is preferably from 10 to 200 parts by mass, more preferably from 20 to 150 parts by mass, and even more preferably from 40 to 100 parts by mass. When the content is within the above range, the miscibility between the organic solvent (a) and the organic solvent (c) is further improved, and continuous discharge stability and low-temperature storage property are more excellent.

The organic solvent may contain an additional solvent (organic solvent) besides the organic solvent (a), the organic solvent (b), and the organic solvent (c). The total content proportion of the organic solvent (a), the organic solvent (b), and the organic solvent (c) in the organic solvent is preferably 50 mass% or more, more preferably 70 mass% or more, even more preferably 80 mass% or more, still more preferably 90 mass% or more, and particularly preferably 95 mass% or more, relative to 100 mass% of the total amount of the organic solvent. When the content proportion is 50 mass% or more, the dispersibility of the metal particles and the miscibility among the organic solvents are more excellent, and the continuous discharge stability, the storage stability, and the suppression of void generation during sintering are more excellent.

When the organic solvent (a), the organic solvent (b), and the organic solvent (c) are mixed in a blending ratio used in the bonding conductive paste, it is preferable that the organic solvent (a), the organic solvent (b), and the organic solvent (c) are homogeneously dissolved at ordinary temperature and do not cause phase separation. In the bonding conductive paste, it is preferable that the organic solvent (a), the organic solvent (b), and the organic solvent (c) are homogeneously dissolved at ordinary temperature and do not cause phase separation. In particular, the organic solvents preferably do not cause phase separation at 22 to 28°C (preferably at 10 to 30°C and more preferably at 0 to 35°C).

Specific examples of the abovementioned binder resin include vinyl chloride-vinyl acetate copolymers, polyvinyl butyral resins, polyester resins, acrylic resins, and cellulosic resins (for example, ethyl cellulose).

Examples of the additives include a surface modifier, a viscosity modifier, a dispersant, and a defoaming agent.

The content of the organic substance in the alloy powder-containing composition per 100 parts by mass of the total of the alloy powder and the metal particles other than the alloy powder is preferably from 0.5 to 50 parts by mass, more preferably from 0.7 to 30 parts by mass, and still more preferably from 8 to 12 parts by mass.

In addition to the alloy powder, the alloy powder-containing composition contains a silver (Ag) powder as the metal particles other than the alloy powder because the silver (Ag) powder can be firmly bonded to the silver (Ag) contained in the AgSi eutectic structure in the alloy powder. As the metal particles other than the alloy powder, one type of silver (Ag) powder may be used alone, or two or more types thereof may be used in combination.

The volume-average particle size (median diameter) of the silver (Ag) powder is preferably from 0.1 to 100 $\mu$m, more preferably from 0.3 to 50 $\mu$m, and even more preferably from 0.5 to 10 $\mu$m. When the volume-average particle size is 0.1 $\mu$m or more, the metal particles are easily handled. In addition, bonding reliability is easily exhibited by setting the volume-average particle size thereof to 100 $\mu$m or less.

The shape of the silver (Ag) powder is not particularly limited, and examples thereof include a spherical shape, a flake shape (flat shape), and a polyhedral shape. Moreover, metal particles of the same shape may be used alone, or metal particles having different shapes may be used in combination. Among these, the shape of the silver (Ag) powder is preferably spherical in order to be appropriately disperse the powder in the alloy powder-containing composition.

The content of the silver (Ag) powder per 100 parts by mass of the alloy powder is preferably from 5 to 2000 parts by mass, more preferably from 10 to 1000 parts by mass, still more preferably from 20 to 500 parts by mass, and particularly preferably from 40 to 400 parts by mass. When the content of the silver (Ag) powder is 5 parts by mass or more, the silver (Ag) powder can be sufficiently bonded to the alloy powder during sinter bonding, and when the content of the silver (Ag) powder is 2000 parts by mass or less, the linear expansion coefficient can be easily reduced.

The content of silver relative to the total amount (100 mass%) of the alloy powder and the silver (Ag) powder is preferably from 20 to 99.9 mass%, more preferably from 25 to 99 mass%, and further preferably from 30 to 90 mass%. When the content of silver (Ag) is 20 mass% or more, bonding reliability is easily exhibited. In addition, when the content thereof is 99.9 mass% or less, the linear expansion coefficient can be kept sufficiently low, and production costs can be kept low while bonding reliability is exhibited.

The alloy powder-containing composition may include other components in addition to the components described above. Examples of the other components include a surfactant other than the organic substance, and a viscosity modifier other than the organic substance. Relative to the total amount of the organic substance, the content of the other components is preferably 5 mass% or less, and may be 3 mass% or less.

Semiconductor Device

An embodiment of the present disclosure is a semiconductor device in which the alloy powder-containing composition (preferably the alloy paste) is used as a bonding layer for bonding a substrate and an object to be bonded. In the semiconductor device, the object to be bonded is bonded to the substrate via a bonding layer, which is a sintered compact of the alloy powder-containing composition. FIG. 3 is a cross-sectional view schematically showing the semiconductor device. Reference numeral 1 denotes the semiconductor device, 10 denotes the substrate, 20 denotes the bonding layer, and 30 denotes the object to be bonded.

Examples of the substrate include metal substrates such as a copper substrate, ceramic substrates, metal-clad ceramic substrates, SiC substrates, gallium nitride substrates, glass-epoxy substrates, BT resin substrates, glass substrates, and resin substrates. Since the alloy paste according to one embodiment of the present disclosure can be sintered at a low temperature, a substrate that is weak against heat can also be used. The substrate is preferably a ceramic substrate or a metal-clad ceramic substrate, and is more preferably a copper-clad ceramic substrate or an aluminum-clad ceramic substrate.

Examples of the object to be bonded include an electronic component and a heat dissipation substrate. Examples of the electronic component include electronic elements (chips, dies) such as a semiconductor element and an LED element, and a specific example of the semiconductor element is a power semiconductor element. The bonded face of the object to be bonded with the bonding layer is preferably silver-plated. Examples of the material of the object to be bonded include Si (silicon), SiC (silicon carbide), GaN, and diamond.

The semiconductor device can be produced by applying the alloy powder-containing composition to a substrate by a printing method (specifically, dispenser printing, mask printing, screen printing, inkjet printing, or the like), placing, on the coating layer, an object to be bonded, and then sintering.

The sintering temperature is, for example, preferably from 150°C to 300°C, more preferably from 160 to 280°C, even more preferably from 200 to 270°C, and particularly preferably from 230 to 260°C. The sintering time is, for example, preferably from 6 minutes to 2 hours, and more preferably from 10 minutes to 1 hour.

The thickness of the bonding layer formed by the above method is preferably from 3 μm to 500 μm, more preferably from 10 to 300 μm, and still more preferably from 40 to 150 μm.

Through the above sintering process, silver (Ag) present in the AgSi eutectic structure of the alloy powder in the alloy powder-containing composition is recrystallized and exuded, whereby silver (Ag) can be firmly bonded to the substrate and the object to be bonded. Further, since the bonding layer contains the alloy powder having a low linear expansion coefficient, the thermal expansion coefficient can be suppressed to a low level while the strength of the bonding portion is increased. Thus, properties such as thermal fatigue resistance of the bonding layer can be essentially improved. Accordingly, a semiconductor device in which the alloy powder-containing composition is used as a bonding layer for bonding a substrate and an object to be bonded can operate at high temperatures and exhibit excellent bonding reliability while complying with environmental regulations.

Each aspect disclosed in the present specification can be combined with another feature disclosed in the present specification. Moreover, each of the configurations, combinations thereof, and the like in each of the embodiments are merely examples, and various additions, omissions, and other changes of the configurations may be made, as appropriate, without departing from the scope of the present disclosure. The present disclosure is not limited by the embodiments and is limited only by the claims.

Example

An embodiment of the present disclosure will be described in more detail below based on Examples.

Production Example 1

Preparation of Alloy Powder

Silver (Ag) ore (purity: 99.99%) and silicon (Si) ore (purity: 99.9999%) were mixed so as to have respective contents of 80 mass% and 20 mass%, and the mixture was heated at 1600°C and melted. The obtained solution was processed into a powder using a gas atomizing device (trade name "RQP-20K", available from Makabe R&D Co., Ltd.), and an alloy powder of Production Example 1 was obtained. The alloy powder was then classified using an ultrasonic vibration sieve (trade name "TSK-DGS", available from Tokyo Screen Co., Ltd.), and particles having a volume-average particle size of 15.86 μm were obtained.

Production Example 2

Silver (Ag) ore (purity: 99.99%) and silicon (Si) ore (purity: 99.9999%) were mixed so as to have respective contents of 50 mass% and 50 mass%, and the mixture was heated at 1600°C and melted. The obtained solution was processed into a powder using a gas atomizing device (trade name "RQP-20K", available from Makabe R&D Co., Ltd.), and an alloy powder of Production Example 2 was obtained. The alloy powder was then classified using an ultrasonic vibration sieve (trade name "TSK-DGS", available from Tokyo Screen Co., Ltd.), and particles having a volume-average particle size of 17.05 μm were obtained.

Production Example 3

Silver (Ag) ore (purity: 99.99%) and silicon (Si) ore (purity: 99.9999%) were mixed so as to have respective contents of 20 mass% and 80 mass%, and the mixture was heated at 1600°C and melted. The obtained solution was processed into a powder using a gas atomizing device (trade name "RQP-20K", available from Makabe R&D Co., Ltd.), and an alloy powder of Production Example 3 was obtained. The alloy powder was then classified using an ultrasonic vibration sieve (trade name "TSK-DGS", available from Tokyo Screen Co., Ltd.), and particles having a volume-average particle size of 16.05 μm were obtained.

Example 1

A paste-like alloy powder-containing composition of Example 1 was prepared by mixing 13.05 g of the alloy powder of Production Example 1, 16.95 g of silver (Ag) particles, and 2.72 g of "Celtol A IP" (trade name, available from Daicel Corporation) as an organic substance.

Example 2

A paste-like alloy powder-containing composition of Example 2 was prepared by mixing 13.00 g of the alloy powder of Production Example 2, 7.00 g of silver (Ag) particles, and 1.40 g of "Celtol A IP" (trade name, available from Daicel Corporation) as an organic substance. The linear expansion coefficient of a sintered compact of the alloy powder-containing composition of Example 2 as measured by the same method as the method described below was 8.

Example 3

A paste-like alloy powder-containing composition of Example 3 was prepared by mixing 8.13 g of the alloy powder of Production Example 3, 11.87 g of silver (Ag) particles, and 1.40 g of "Celtol A IP" (trade name, available from Daicel Corporation) as an organic substance. The linear expansion coefficient of a sintered compact of the alloy powder-containing composition of Example 3 as measured by the same method as the method described below was 8.

Example 4

A paste-like alloy powder-containing composition of Example 4 was prepared by mixing 6.00 g of the alloy powder of Production Example 2, 14.00 g of silver (Ag) particles, and 1.40 g of "Celtol A IP" (trade name, available from Daicel Corporation) as an organic substance. The linear expansion coefficient of a sintered compact of the alloy powder-containing composition of Example 4 as measured by the same method as the method described below was 12.

Example 5

A paste-like alloy powder-containing composition of Example 5 was prepared by mixing 3.75 g of the alloy powder of Production Example 3, 16.25 g of silver (Ag) particles, and 0.70 g of "Celtol A IP" (trade name, available from Daicel Corporation) as an organic substance. The linear expansion coefficient of a sintered compact of the alloy powder-containing composition of Example 5 as measured by the same method as the method described below was 12.

Comparative Example 1

A paste of Comparative Example 1 was prepared by mixing 1.73 g of "Celtol A IP" (trade name, available from Daicel Corporation) as an organic substance with 20 g of only silver (Ag) particles in place of the alloy powder of Example 1.

Comparative Example 2

A paste of Comparative Example 2 was prepared by mixing 27.39 g of silver (Ag) particles, 2.61 g of silicon (Si) particles, and 8.29 g of "Celtol A IP" (trade name, available from Daicel Corporation) as an organic substance.

Evaluation

The physical properties of the pastes of the above examples and comparative examples were evaluated, and the results are presented in Tables 1 and 2.

(1) Mounting Properties

(1) -1. Mounting Temperature

The pastes of Example 1 and Comparative Examples 1 and 2 were heated for 30 minutes, and when bonding occurred at a temperature of 300°C or lower, the paste was evaluated as ∘, when bonding occurred at a temperature of 250°C or lower, the paste was evaluated as being ◎, and when bonding did not occur at a temperature of 300°C or lower, the paste was evaluated as ×.

(1) -2. Mounting Time

The pastes of Example 1 and Comparative Examples 1 and 2 were heated at a temperature of 250°C and a pressure of 20 MPa, and when bonding occurred within 60 minutes, the paste was evaluated as ∘, when bonding occurred within 30 minutes, the paste was evaluated as ◎, and when bonding did not occur within 60 minutes, the paste was evaluated as ×.

(1) -3. Mounting Pressure

The pastes of Example 1 and Comparative Examples 1 and 2 were heated at a temperature of 250°C and a pressure of 20 MPa for 60 minutes, and when all the metal particles were bonded but voids occurred, the paste was evaluated as ∘, when all the metal particles were bonded and voids did not occur, the paste was evaluated as ⊚, and when metal particles that were not bonded were present, the paste was evaluated as ✕.

(2) Bonding Reliability

(2) -1. Linear Expansion Coefficient

The pastes of Example 1 and Comparative Examples 1 and 2 were sintered in a button shape to prepare test pieces. Each test piece was measured with a thermomechanical analyzer (device name "TMA-60", available from Shimadzu Corporation), and a test piece with a linear expansion coefficient of 19 or less was evaluated as ∘, a test piece with a linear expansion coefficient of 16 or less was evaluated as ⊚, and a test piece with a linear expansion coefficient of more than 19 was evaluated as ✕.

(2) -2. Structural Change

Each paste of Example 1 and Comparative Examples 1 and 2 was left to stand in a thermostatic chamber (trade name "DKN303", available from Yamato Scientific Co., Ltd.) at 250°C for 100 hours, after which the metal structure of the paste was observed. A paste in which significant coarsening of the metal structure was confirmed was evaluated as ✕, and a paste in which significant coarsening did not occur was evaluated as ∘.

(2) -3. Strength Retention Ratio

The pastes of Examples 2 to 5 and Comparative Example 1 were formed into a 3 mm $\times$ 3 mm shape and used to paste together a copper substrate and SiC. The resulting semiconductor device was sintered for 30 minutes at a pressure of 20 MPa and a temperature of 300°C. The shear bonding strength of the above semiconductor device was then measured at room temperature and a test speed of 50 $\mu$m/s using a die shear tester (trade name "SERIES 4000", available from DAGE Corporation). The semiconductor device was also subjected to a thermal shock test in which heating and cooling in a temperature range of from -50 to 250°C was set as one cycle, and 500 cycles and 1000 cycles were repeated, and after the thermal shock test, the shear bonding strength was measured under the same conditions, and the retention ratio of the shear bonding strength before and after the thermal shock test ((shear bonding strength after thermal shock test)/(shear bonding strength before thermal shock test) $\times$ 100) was calculated as the strength retention ratio (%). A strength retention ratio of 60% or more was evaluated as ⊚, a strength retention ratio of 50% or more was evaluated as ∘, and a strength retention ratio of less than 50% was evaluated as ✕.

[Table 1]

Table 1

| | Mounting Properties | | | Bonding Reliability | |
|---|---|---|---|---|---|
| | Mounting Temperature | Mounting Time | Mounting Pressure | Linear Expansion Coefficient | Structural Change at High Temperatures |
| Example 1 | ⊚ | ◯ | ◯ | ⊚ | ◯ |
| Comparative Example 1 | ⊚ | ◯ | ◯ | ✕ | ✕ |
| Comparative Example 2 | ⊚ | ◯ | ✕ | ⊚ | ◯ |

[Table 2]

Table 2

| | | Comparative Example 1 | Example 2 | Example 3 | Example 4 | Example 5 |
|---|---|---|---|---|---|---|
| Strength Retention Ratio (%) | 500 cycles | × | ◎ | ◎ | ◎ | ◎ |
| | 1000 cycles | × | ◎ | ◎ | ○ | ○ |

It was confirmed that the alloy powder-containing compositions of the examples exhibited bonding reliability at high temperatures while excelling in mounting properties. On the other hand, it was also confirmed that when Ag paste was used (Comparative Example 1), the linear expansion coefficient was high, structural changes occurred at high temperatures, and the strength retention ratio was inferior, and thus the bonding reliability was also inferior. In addition, in the case of the alloy powder-containing composition in which a mixed powder of silver particles and silicon particles was used (Comparative Example 2), it was confirmed that the formation of an alloy between Ag and Si was incomplete, pressurization at the time of mounting was essential, and the mounting properties were inferior as compared with the Ag-Si alloy particles of Example 1.

Hereinafter, variations of the present disclosure will be described.

[Addendum 1]

An alloy powder-containing composition containing: an alloy powder having an AgSi eutectic structure; a silver (Ag) powder; and an organic substance.

[Addendum 2]

The alloy powder-containing composition according to addendum 1, in which sintering can be carried out at a temperature of from 150 to 300°C.

[Addendum 3]

The alloy powder-containing composition according to addendum 1 or 2, in which a strength retention ratio (%) is 50% or more, the strength retention ratio being calculated as a ratio of a shear bonding strength after a thermal shock test in which the semiconductor device is repeatedly heated and cooled in a range of from -50 to 250°C for a specific number of times, to a shear bonding strength before the thermal shock test ((shear bonding strength after thermal shock test)/(shear bonding strength before thermal shock test) × 100), both shear bonding strengths being measured using a die shear tester at conditions of room temperature and a test speed of 50 μm/s.

[Addendum 4]

The alloy powder-containing composition according to any one of addenda 1 to 3, in which a linear expansion coefficient measured by a thermomechanical analyzer is 17 or less.

[Addendum 5]

The alloy powder-containing composition according to any one of addenda 1 to 4, in which a metal structure observed after the alloy powder-containing composition is left to stand at 250°C for 100 hours does not exhibit significant coarsening.

[Addendum 6]

The alloy powder-containing composition according to any one of addenda 1 to 5, in which a proportion of the AgSi eutectic structure is 10% or more in at least 8 or more of 10 particles when any 10 adjacent particles of the alloy powder are subjected to a method including selecting one particle from an image captured at a magnification of from 2000 to 50000 times, measuring a total outer peripheral length of the particle and a length of an outer peripheral portion where a eutectic structure is present, a region where no eutectic structure is present in a region from an outer periphery to a depth of 0.2 μm in a direction toward a center of the particle being excluded from the outer peripheral portion, and calculating a proportion of the length of the outer peripheral portion thereof to the total outer peripheral length as the proportion of the AgSi structure on the particle surface.

[Addendum 7]

The alloy powder-containing composition according to any one of addenda 1 to 6, in which a content of silver (Ag) relative to a total amount of the alloy powder is from 15 to 97.6 mass%.

[Addendum 8]

The alloy powder-containing composition according to any one of addenda 1 to 7, in which a content of silicon (Si) relative to the total amount of the alloy powder is from 2.4 to 85 mass%.

[Addendum 9]

The alloy powder-containing composition according to any one of addenda 1 to 8, in which the alloy powder is spherical.

[Addendum 10]

The alloy powder-containing composition according to any one of addenda 1 to 9, in which a content of the silver (Ag) powder is from 5 to 2000 parts by mass per 100 parts by mass of the alloy powder.

[Addendum 11]

The alloy powder-containing composition according to any one of addenda 1 to 10, in which the content of silver relative to a total amount of the alloy powder and the silver (Ag) powder is from 20 to 99.9 mass%.

[Addendum 12]

The alloy powder-containing composition according to any one of addenda 1 to 11, in which the alloy powder has a volume-average particle size (median diameter) of from 0.1 to 100 $\mu$m.

[Addendum 13]

The alloy powder-containing composition according to any one of addenda 1 to 12, in which the silver (Ag) powder has a volume-average particle size (median diameter) of from 0.1 to 100 $\mu$m.

[Addendum 14]

The alloy powder-containing composition according to any one of addenda 1 to 13, in which the silver (Ag) powder is spherical.

[Addendum 15]

The alloy powder-containing composition according to any one of addenda 1 to 14, in which the organic substance is an organic solvent.

[Addendum 16]

A semiconductor device including the alloy powder-containing composition described in any one of addenda 1 to 15, the alloy powder-containing composition being used as a bonding layer for bonding a substrate and an object to be bonded.

Reference Signs List

1 Semiconductor device
10 Substrate
20 Bonding layer

30 Object to be bonded

**Claims**

1. An alloy powder-containing composition comprising: an alloy powder having an AgSi eutectic structure; a silver (Ag) powder; and an organic substance.

2. The alloy powder-containing composition according to claim 1, wherein a content of silver (Ag) relative to a total amount of the alloy powder is from 15 to 97.6 mass%.

3. The alloy powder-containing composition according to claim 1 or 2, wherein a content of the silver (Ag) powder is from 5 to 2000 parts by mass per 100 parts by mass of the alloy powder.

4. The alloy powder-containing composition according to claim 1 or 2, wherein the content of silver relative to a total amount of the alloy powder and the silver (Ag) powder is from 20 to 99.9 mass%.

5. The alloy powder-containing composition according to claim 1 or 2, wherein the alloy powder has a volume-average particle size (median diameter) of from 0.1 to 100 μm.

6. A semiconductor device comprising the alloy powder-containing composition described in claim 1 or 2, the alloy powder-containing composition being used as a bonding layer for bonding a substrate and an object to be bonded.

FIG. 1

FIG. 2

FIG. 3

# EP 4 775 327 A1

## INTERNATIONAL SEARCH REPORT

| International application No. |
|---|
| **PCT/JP2024/031626** |

### A. CLASSIFICATION OF SUBJECT MATTER

***B22F 1/00***(2022.01)i; ***B22F 1/14***(2022.01)i; ***B22F 1/052***(2022.01)i; ***B22F 7/08***(2006.01)i; ***B22F 9/00***(2006.01)i; ***C22C 5/06***(2006.01)i; ***H01L 21/52***(2006.01)i

FI: B22F1/00 K; B22F1/052; B22F1/14 500; B22F7/08 C; B22F9/00 B; C22C5/06 Z; H01L21/52 E

According to International Patent Classification (IPC) or to both national classification and IPC

### B. FIELDS SEARCHED

Minimum documentation searched (classification system followed by classification symbols)

B22F1/00; B22F1/14; B22F1/052; B22F7/08; B22F9/00; C22C5/06; H01L21/52

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2021/039874 A1 (DAICEL CORP.) 04 March 2021 (2021-03-04)<br>  paragraphs [0038], [0062], [0063], [0066] | 1-6 |
| A | JP 2015-218372 A (MITSUBISHI ELECTRIC CORPORATION) 07 December 2015 (2015-12-07)<br>  paragraphs [0010], [0019]-[0021] | 1-6 |

☐ Further documents are listed in the continuation of Box C.    ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **02 October 2024** | **15 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

16

**INTERNATIONAL SEARCH REPORT**
Information on patent family members

International application No.

**PCT/JP2024/031626**

| Patent document cited in search report | | | Publication date (day/month/year) | Patent family member(s) | | | Publication date (day/month/year) |
|---|---|---|---|---|---|---|---|
| WO | 2021/039874 | A1 | 04 March 2021 | TW | 202126404 | A | |
| JP | 2015-218372 | A | 07 December 2015 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023146496 A
- JP 2003311469 A
- JP 2020069517 A
- JP 2019056158 A